# FASCICULE DE BREVET EUROPEEN

(11) **EP 3 877 773 B1**
(45) Date de publication et mention de la délivrance du brevet: **06.03.2024**
(21) Numéro de dépôt: 19795556.0
(22) Date de dépôt: 30.10.2019
(51) Int. Cl.: G01R 31/11

(54) **SYSTEME D'ANALYSE DE DEFAUTS PAR REFLECTOMETRIE A DYNAMIQUE OPTIMISEE**
SYSTEM ZUR ANALYSE VON FEHLERN DURCH REFLEKTOMETRIE MIT OPTIMIERTEM DYNAMIKBEREICH
SYSTEM FOR ANALYSING FAULTS BY REFLECTOMETRY OF OPTIMISED DYNAMIC RANGE

(30) Priorité: 09.11.2018 FR 1860328
(43) Date de publication de la demande: 15.09.2021
(73) Titulaire: Commissariat à l'Energie Atomique et aux Energies Alternatives, 75015 Paris (FR)
(72) Inventeur: CABANILLAS, Esteban, 91400 ORSAY (FR); DUPRET, Antoine, 91400 ORSAY (FR); VINCENT, Pierre, 38250 VILLARS DE LANS (FR)
(74) Mandataire: Atout PI Laplace
(86) Numéro de dépôt international: PCT/EP2019/079577
(87) Numéro de publication internationale: WO 2020/094469

(56) Documents cités:
- WO-A1-2014/180663
- FR-A1- 3 034 203

## Description

L'invention concerne le domaine des systèmes de diagnostic filaire basés sur le principe de la réflectométrie. Elle porte plus précisément sur un système à dynamique optimisée intégrant un organe de calibration permettant de supprimer, dans le signal prélevé sur le câble à tester, un ou plusieurs pics associés à des discontinuités d'impédance induites par la désadaptation entre l'équipement de mesure et le câble ou par des points particuliers de la topologie d'un réseau de câbles.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts qui impactent ces câbles, ces informations incluant l'existence de défauts mais aussi leur localisation et leur type. L'analyse de défauts permet d'aider à la maintenance des câbles. Les méthodes de réflectométrie usuelles permettent ce type d'analyse.

Les méthodes de réflectométrie utilisent un principe proche de celui du radar : un signal électrique, le signal de sonde ou signal de référence, est injecté en un ou plusieurs endroits du câble à tester. Le signal se propage dans le câble ou le réseau de câbles et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

L'invention entre dans le champ d'application des méthodes de diagnostic filaire par réflectométrie et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie en un point du câble et de mesurer sa réflexion au même point ou en un autre point.

La précision des méthodes de réflectométrie appliquées au diagnostic de défauts sur des lignes de transmission est fortement liée à la fréquence des signaux de réflectométrie utilisés. Par ailleurs, l'atténuation que subit un signal lors de sa propagation le long d'un câble est aussi une fonction de la fréquence. Cette atténuation augmente lorsque la fréquence du signal augmente. L'atténuation que subit le signal après sa rétro-propagation jusqu'au système de réflectométrie dégrade fortement la sensibilité du système qui est déterminée par la résolution du convertisseur analogique numérique et son bruit de quantification. En effet, pour détecter et localiser des défauts superficiels encore appelés défauts non francs, le système doit être capable de discriminer, dans le réflectogramme calculé, des pics de faible amplitude qui peuvent être noyés dans le bruit de quantification du convertisseur. Il est donc nécessaire, pour cela, de pouvoir amplifier le signal mesuré afin d'améliorer la détection de ces pics.

Cependant, un autre facteur contraignant la sensibilité du système est la désadaptation d'impédance entre la carte électronique réalisant le système de réflectométrie et le câble à diagnostiquer. En effet, l'impédance du coupleur qui connecte la carte au câble n'est, le plus souvent, pas adaptée à l'impédance du câble qui varie selon la nature des câbles à tester. Ainsi, une part de l'énergie émise par le système de réflectométrie est réfléchie au niveau de cette interface de couplage. Le signal acquis est donc composé d'une superposition d'échos induits par des ruptures d'impédances. Hors, le niveau de l'écho lié à l'interface de couplage est prédominant dans le signal acquis car il n'est pas atténué par les pertes de propagation du câble. Cette désadaptation d'impédance définie la dynamique maximale du signal reçu que le système est capable de traiter. Ainsi, l'amplification du signal mesuré est limitée par le niveau de l'écho du signal sur l'interface de couplage. Il n'est donc pas possible d'amplifier suffisamment le signal mesuré pour amplifier les signatures de défauts non francs sans saturer la dynamique du convertisseur analogique-numérique.

La demande internationale WO 2014/180663 décrit un exemple de système de réflectométrie selon l'art antérieur.

L'invention propose un système de réflectométrie qui permet d'atténuer ou supprimer l'écho du signal lié à la désadaptation d'impédance sur l'interface de couplage afin de permettre une adaptation de la dynamique du convertisseur analogique-numérique aux signaux de faible amplitude correspondant à des défauts non francs du câble.

Ainsi, l'invention permet d'amplifier les pics d'amplitude correspondant à des défauts non francs à localiser, sans saturer la dynamique du convertisseur analogique-numérique.

Par ailleurs, l'invention peut être généralisée afin de supprimer tous les échos du signal associés à des réflexions sur des discontinuités d'impédance liées à la topologie d'un réseau de câbles à diagnostiquer. De telles discontinuités d'impédance peuvent notamment apparaître au niveau d'une jonction entre deux sections de câbles d'impédances différentes ou à l'extrémité d'un câble ou d'une section d'un câble.

L'invention selon la revendication 1 a pour objet un système d'analyse, par réflectométrie, de défauts dans une ligne de transmission, le système comprenant un générateur de signal de test, un coupleur pour injecter le signal de test dans la ligne de transmission et prélever le signal rétro-propagé dans la ligne de transmission, une unité de contrôle configurée pour générer un signal de calibration égal à l'opposé du signal de test et contrôler sa phase et son amplitude, au moins un combineur pour combiner le signal de calibration et le signal prélevé par le coupleur en un signal corrigé, un amplificateur pour amplifier le signal corrigé et un corrélateur pour corréler le signal corrigé et le signal de test pour produire un réflectogramme, l'unité de contrôle étant en outre configurée pour faire varier l'amplitude et la phase du signal de calibration de manière à supprimer, dans le signal prélevé par le coupleur, au moins un écho du signal de test sur au moins un point de désadaptation d'impédance de la ligne de transmission.

Selon un aspect particulier de l'invention, le point de désadaptation d'impédance est le point de jonction entre le coupleur et la ligne de transmission.

Selon un aspect particulier de l'invention, l'unité de contrôle est configurée pour déterminer l'amplitude et la phase du signal de calibration en analysant le réflectogramme calculé par le corrélateur, les valeurs choisies de l'amplitude et de la phase étant celles permettant d'annuler, dans le réflectogramme, un pic d'amplitude correspondant à l'au moins un écho du signal de test sur au moins un point de désadaptation d'impédance de la ligne de transmission.

Selon un aspect particulier, le système selon l'invention comprend un premier convertisseur numérique-analogique connecté entre le générateur de signal de test et le coupleur, au moins un deuxième convertisseur numérique-analogique connecté entre l'unité de contrôle et l'au moins un combineur et un convertisseur analogique-numérique connecté entre l'amplificateur et le corrélateur.

Selon un aspect particulier de l'invention, l'unité de contrôle est en outre configurée pour régler le gain d'amplification de l'amplificateur de manière à ce que le signal analogique corrigé occupe toute la dynamique du convertisseur analogique-numérique lorsque l'au moins un écho est supprimé dans le signal prélevé par le coupleur.

Selon un aspect particulier de l'invention, l'unité de contrôle est configurée pour régler le gain d'amplification de l'amplificateur en fonction d'un indicateur de saturation du convertisseur analogique-numérique.

Selon un aspect particulier de l'invention, l'unité de contrôle est configurée pour régler le gain d'amplification de l'amplificateur en fonction d'un critère de rapport signal à bruit mesuré sur le réflectogramme calculé par le corrélateur.

Selon un aspect particulier de l'invention, l'unité de contrôle est configurée pour supprimer, dans le signal prélevé par le coupleur, plusieurs échos du signal de test sur plusieurs points de désadaptation d'impédance de la ligne de transmission en exécutant successivement les étapes suivantes, pour chaque écho à supprimer :
- Générer un signal de calibration égal à l'opposé du signal de test
- Déterminer l'amplitude et la phase du signal de calibration de manière à supprimer, dans le signal prélevé par le coupleur, l'écho.

Selon un aspect particulier de l'invention, les points de désadaptation d'impédance comprennent au moins le point de jonction entre le coupleur et la ligne de transmission et un point parmi un point de jonction entre deux tronçons de la ligne de transmission ou une extrémité d'une jonction de la ligne de transmission.

Selon une variante particulière, le système selon l'invention comprend un premier convertisseur numérique-analogique ayant une première fréquence et un second convertisseur numérique-analogique ayant une seconde fréquence supérieure à la première fréquence.

Selon une variante particulière, le système selon l'invention comprend plusieurs convertisseurs numérique-analogique identiques agencés entre une sortie de l'unité de contrôle et une entrée du combineur pour convertir respectivement, chacun des signaux de calibration générés par l'unité de contrôle en signaux analogiques.

Selon une variante particulière, le système selon l'invention comprend plusieurs combineurs agencés en cascade, chaque combineur ayant une entrée reliée à une sortie d'un convertisseur numérique-analogique.

Selon une variante particulière, le système selon l'invention comprend un dispositif d'analyse du réflectogramme calculé par le corrélateur pour analyser la présence de défaut sur la ligne de transmission.

L'invention a aussi pour objet un procédé d'analyse selon la revendication 14, par réflectométrie, de défauts dans une ligne de transmission, le procédé comprenant les étapes de :
- Injecter un signal de test au moyen d'un coupleur connecté à la ligne de transmission,
- Acquérir un signal rétro-propagé dans la ligne de transmission, au moyen du coupleur,
- Générer un signal de calibration égal à l'opposé du signal de test et ayant une amplitude et une phase contrôlable,
- Combiner le signal de calibration et le signal rétro-propagé pour obtenir un signal corrigé,
- Déterminer l'amplitude et la phase du signal de calibration de manière à supprimer, dans le signal rétro-propagé, au moins un écho du signal de test sur au moins un point de désadaptation d'impédance de la ligne de transmission.

Selon une variante particulière, le procédé selon l'invention comprend les étapes de :
- Corréler le signal corrigé et le signal de test pour obtenir un réflectogramme,
- Déterminer l'amplitude et la phase du signal de calibration de sorte à annuler, dans le réflectogramme, un pic d'amplitude correspondant à l'au moins un écho du signal de test.

Selon une variante particulière, le procédé selon l'invention comprend les étapes de :
- déterminer un gain d'amplification du signal corrigé de manière à ce que le signal corrigé occupe toute la dynamique du convertisseur analogique-numérique lorsque l'au moins un écho est supprimé dans le signal prélevé par le coupleur.
- Amplifier le signal corrigé avec le gain d'amplification.

D'autres caractéristiques et avantages de la présente invention apparaîtront mieux à la lecture de la description qui suit en relation aux dessins annexés qui représentent :

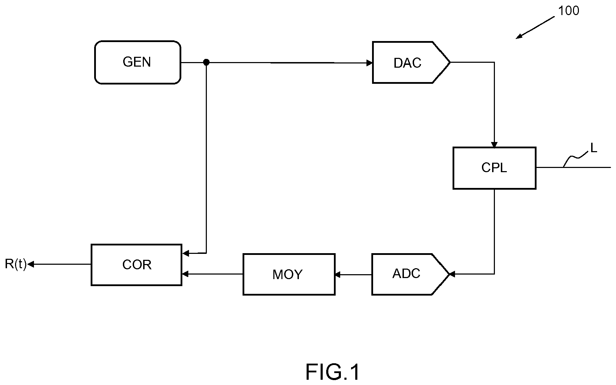

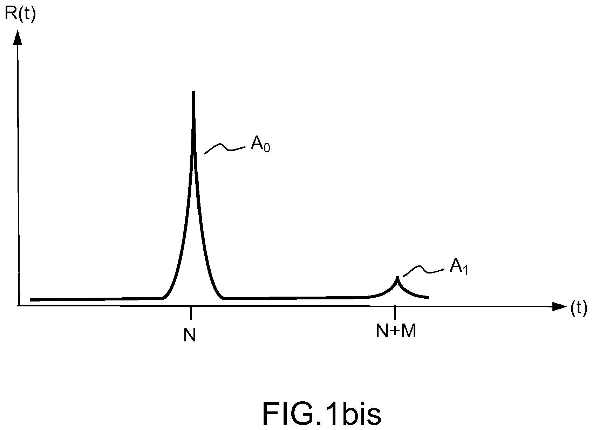

- La figure 1, un schéma d'un système de réflectométrie selon l'art antérieur,
- La figure 1 bis, un exemple de réflectogramme obtenu avec le système de réflectométrie de la figure 1,
- La figure 2, un schéma d'un système de réflectométrie amélioré selon un premier mode de réalisation de l'invention,
- Les figures 3a et 3b, plusieurs diagrammes temporels illustrant la mise au point d'un signal de calibration,
- La figure 4, un diagramme temporel illustrant la mise au point d'un gain d'amplification selon un mode de réalisation de l'invention,
- La figure 5, un schéma illustrant une variante du problème à résoudre par l'invention,
- La figure 6, un schéma d'un système de réflectométrie selon une variante d'un second mode de réalisation de l'invention,
- La figure 7, un schéma d'un système de réflectométrie selon une autre variante d'un second mode de réalisation de l'invention,
- La figure 8, un organigramme décrivant les étapes de mise en oeuvre d'un procédé de réflectométrie selon l'invention.

La figure 1 représente un schéma d'un système 100 d'analyse de défaut dans une ligne de transmission L, telle qu'un câble, selon une méthode usuelle de réflectométrie temporelle de l'état de l'art. Un tel système comprend principalement un générateur GEN d'un signal de référence. Le signal de référence numérique généré est converti analogiquement via un convertisseur numérique-analogique DAC puis est injecté en un point de la ligne de transmission L au moyen d'un coupleur directionnel CPL ou tout autre dispositif permettant d'injecter un signal dans une ligne. Le signal se propage le long de la ligne et se réfléchit sur les singularités qu'elle comporte. En l'absence de défaut sur la ligne, le signal se réfléchit sur l'extrémité de la ligne si la terminaison de la ligne est non adaptée. En présence de défaut sur la ligne, le signal se réfléchit sur la discontinuité d'impédance provoquée par le défaut. Le signal réfléchi est rétro-propagé jusqu'à un point de mesure, qui peut être commun au point d'injection ou différent. Le signal rétro-propagé est mesuré via le coupleur directionnel CPL puis converti numériquement par un convertisseur analogique numérique ADC. Une corrélation COR est ensuite effectuée entre le signal numérique mesuré et une copie du signal numérique généré avant injection afin de produire un réflectogramme temporel R(t) correspondant à l'inter-corrélation entre les deux signaux.

Comme cela est connu dans le domaine des méthodes de diagnostic par réflectométrie temporelle, la position d_{DF} d'un défaut sur le câble L, autrement dit sa distance au point d'injection du signal, peut être directement obtenue à partir de la mesure, sur le réflectogramme temporel calculé R(t), de la durée t_{DF} entre le premier pic d'amplitude relevé sur le réflectogramme et le pic d'amplitude correspondant à la signature du défaut.

La figure 1 bis représente un exemple de réflectogramme R(t) obtenu à l'aide du système de la figure 1, sur lequel on observe un premier pic d'amplitude A₀ à une abscisse N et un second pic d'amplitude A_{M} à une abscisse N+M. Le premier pic d'amplitude correspond à la réflexion du signal au point d'injection dans le câble, tandis que le second pic correspond à la réflexion du signal sur une discontinuité d'impédance provoquée par un défaut

Différentes méthodes connues sont envisageables pour déterminer la position d_{DF}. Une première méthode consiste à appliquer la relation liant distance et temps : d_{DF =} V_{g} ·t_{DF}/2 où V_{g} est la vitesse de propagation du signal dans le câble. Une autre méthode possible consiste à appliquer une relation de proportionnalité du type d_{DF}/ t_{DF} = L_{c}/t₀ où L_{c} est la longueur du câble et t₀ est la durée, mesurée sur le réflectogramme, entre le pic d'amplitude correspondant à la discontinuité d'impédance au point d'injection et le pic d'amplitude correspondant à la réflexion du signal sur l'extrémité du câble. Afin de diminuer le niveau du bruit de mesure, un calcul de moyenne MOY optionnel peut être réalisé avant ou après la corrélation COR. Les deux emplacements du calcul de moyenne sont équivalents d'un point de vue arithmétique.

Un dispositif d'analyse (non représenté à la figure 1) est chargé d'analyser le réflectogramme R(t) pour en déduire des informations de présence et/ou localisation de défauts ainsi que les caractéristiques électriques éventuelles des défauts.

Le système de la figure 1 présente les limitations discutées en préambule. L'écho du signal injecté dans la ligne de transmission L sur la désadaptation d'impédance entre le coupleur CPL et la ligne est superposé au signal rétro-propagé au travers de la ligne L. Cet écho n'étant pas atténué, il tend à saturer la dynamique du convertisseur analogique-numérique ADC de sorte qu'il n'est pas possible d'amplifier les pics d'amplitude A_{M} correspondant à des défauts non francs sur la ligne L.

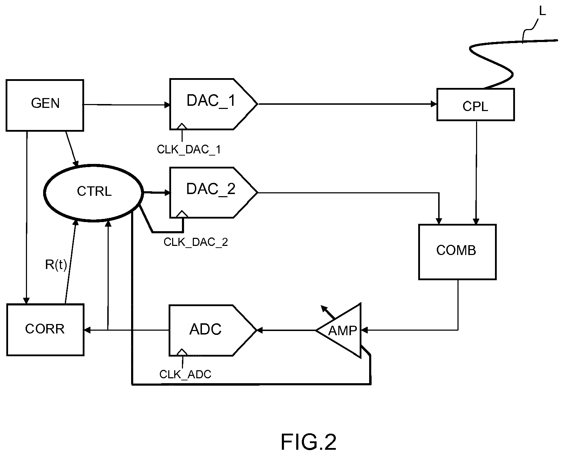

Le système de la figure 2 est proposé pour remédier aux inconvénients précités. Il comporte certains éléments identiques au système décrit à la figure 1, notamment un générateur GEN d'un signal de test numérique, un premier convertisseur numérique analogique DAC_1, un coupleur CPL pour injecter le signal de test dans une ligne de transmission L à diagnostiquer et acquérir un écho du signal rétro-propagé dans la ligne, un convertisseur analogique numérique ADC et un corrélateur CORR pour produire un réflectogramme du type de celui de la figure 1bis à partir du signal acquis et du signal généré par le générateur GEN.

Le signal de test utilisé peut être tout type de signal de réflectométrie temporelle ou fréquentielle. Par exemple, il peut s'agir d'un signal multi-porteuses de type OMTDR (Orthogonal Multi-tone Time Division Multiplexing). Le signal de test peut être périodique de sorte à être injecté en continu dans la ligne L sous forme de séquences répétées.

Le système selon un mode de réalisation de l'invention décrit à la figure 2 comporte en outre une unité de contrôle CTRL, un second convertisseur numérique-analogique DAC_2, un combineur COMB et un amplificateur AMP.

L'unité de contrôle CTRL est configurée pour générer un signal de calibration opposé par rapport au signal de test produit par le générateur GEN. Le signal opposé y est composé des échantillons du signal de test x auxquels on applique un signe opposé, y=-x. Par ailleurs, la phase et l'amplitude du signal de calibration sont réglables. Le signal de calibration est converti en signal analogique (par le convertisseur DAC_2) puis combiné au signal acquis par le coupleur CPL au moyen d'un combineur COMB passif ou actif qui est un composant apte à sommer deux signaux analogiques. Le signal corrigé en sortie du combineur COMB est amplifié par un amplificateur AMP puis converti numériquement (par le convertisseur ADC). Un réflectogramme est calculé par le corrélateur CORR qui le transmet à l'unité de contrôle CTRL qui ajuste la phase et l'amplitude du signal de calibration de manière à annuler l'écho du signal sur l'interface de couplage entre le coupleur et la ligne L, dans le signal de sortie du combineur COMB.

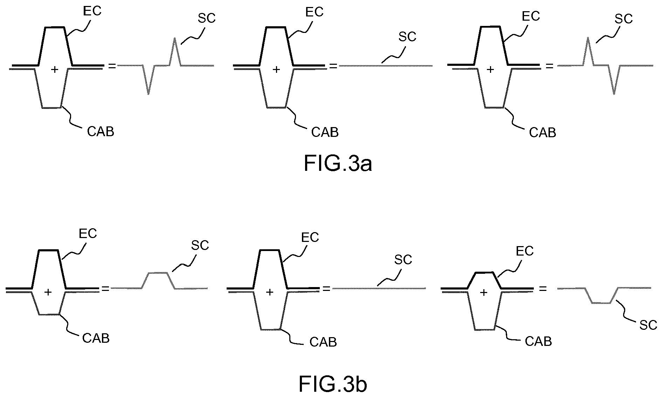

Une fonction de l'unité de contrôle CTRL consiste à générer un signal qui permette, après combinaison avec le signal prélevé par le coupleur CPL, d'annuler l'écho du signal injecté sur l'interface de couplage entre le coupleur et la ligne L. Cet écho correspond, dans le réflectogramme calculé par le corrélateur CORR au premier pic d'amplitude A1. Pour annuler cet écho, une méthode possible consiste à ajuster la phase (ou le retard) et l'amplitude du signal de calibration de la manière illustrée sur les figures 3a et 3b.

Sur la figure 3a, on a représenté trois diagrammes temporels représentant les réflectogrammes temporels correspondants d'une part à l'écho EC du signal à annuler et au signal de calibration CAB et d'autre part, à la superposition des deux signaux après leur combinaison, autrement dit au signal de sortie SC du combineur COMB. Dans tous les cas, le signal de calibration CAB est opposé par rapport à l'écho EC.

Sur la figure 3a, on a illustré un premier cas (figure de gauche) pour lequel le signal de calibration CAB présente un décalage de phase ou un retard par rapport à l'écho EC, un second cas (figure de droite) présentant également un décalage de phase entre ces deux signaux et un troisième cas (figure du milieu) pour lequel les deux signaux EC,CAB sont en phase et le signal résultant de la combinaison des deux est nul.

De la même façon, on a représenté sur la figure 3b, deux cas (figures de droite et gauche) pour lesquels l'amplitude du signal de calibration CAB est différente de celle de l'écho EC et un troisième cas (figure du milieu) pour lequel les deux signaux EC,CAB ont la même amplitude absolue et le signal résultant de la combinaison des deux est nul.

Les figures 3a et 3b illustrent une méthode permettant de déterminer l'amplitude et la phase du signal de calibration CAB.

Dans une première étape, le signal de calibration est généré comme étant égal à l'opposé du signal de test et avec une amplitude atténuée d'au moins la moitié par rapport à l'amplitude du signal de test.

Ensuite, le signal de calibration est transmis sur l'entrée du combineur COMB et un réflectogramme est calculé par le corrélateur CORR. En analysant ce réflectogramme, l'unité de contrôle ajuste soit la phase, soit l'amplitude du signal de calibration, soit les deux en même temps, pour arriver à annuler le premier pic du réflectogramme comme illustré sur les diagrammes du milieu des figures 3a et 3b. En effet, lorsqu'un des deux signaux est retardé, la somme des deux signaux autour de la zone de désadaptation a un comportement oscillant, passant d'un pic positif vers un pic négatif ou vice versa.

L'ajustement peut être fait de façon itérative en plusieurs itérations des deux étapes précédentes. A chaque itération, le signal de calibration est modifié, par exemple par un incrément de phase ou d'amplitude, puis le réflectogramme résultant est analysé et ce jusqu'à annuler le premier pic correspondant à l'écho EC.

Un critère possible pour arrêter les itérations consiste à calculer un critère d'erreur dans la zone temporelle autour du premier pic du réflectogramme et à comparer cette erreur à un seuil en dessous duquel, on considère que le pic est sensiblement nul. Tout critère équivalent exploitant la somme, la moyenne ou tout type de distance mathématique adaptée peut être utilisé pour automatiser cette méthode. Par exemple, un critère simple consiste à sommer les valeurs des points du réflectogramme dans une zone temporelle autour du pic que l'on souhaite annuler. Cette somme est ensuite comparée à un seuil en dessous duquel, le pic est considéré comme étant suffisamment atténué.

Une fois que la phase et l'amplitude du signal de calibration CAB sont déterminées, le système est apte à pouvoir amplifier les signaux acquis par le coupleur CPL sans saturer la dynamique du convertisseur analogique numérique ADC.

Le gain de l'amplificateur AMP est réglé de sorte à amplifier le signal sans saturer le convertisseur ADC tout en permettant une meilleure détection des pics de faible amplitude correspondant aux défauts non francs.

Pour régler ce gain, une première méthode consiste à faire varier le gain d'amplification et à analyser le signal en sortie du convertisseur ADC pour détecter le nombre d'échantillons qui sont saturés. Lorsque le nombre d'échantillons ou le taux d'échantillons dépasse un seuil prédéterminé, on décide que le gain est optimal et qu'au-delà de ce gain, une saturation trop importante va intervenir. Le seuil est par exemple égal à 1/3 des échantillons saturés.

Une seconde méthode consiste à faire varier le gain d'amplification et à analyser les réflectogrammes déterminés par le corrélateur CORR pour chaque gain.

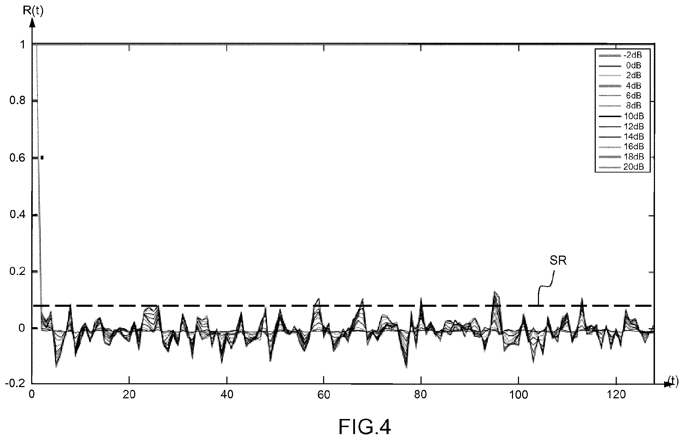

La figure 4 représente un diagramme temporel sur lequel sont illustrés plusieurs réflectogrammes obtenus pour différentes valeurs de gain variant de -2dB à 20 dB en l'absence de défauts. Un seuil S_{R} est fixé et comparé à l'ensemble des points du réflectogramme. Le seuil S_{R} correspond à un seuil de détection de défauts. Autrement dit, il est fixé de sorte à pouvoir détecter des défauts non francs dont la signature est supérieure à ce seuil. Plus ce seuil est bas, plus il est possible de détecter des signatures de faible amplitude. Par contre, le taux de fausse alarme va aussi augmenter car le bruit lié à la saturation du signal acquis engendre des pics qui peuvent être confondus avec des signatures de défaut. En effet, lorsque le signal acquis par le convertisseur analogique-numérique ADC est saturé, cela engendre un bruit en sortie du calcul de corrélation. Plus le convertisseur ADC est saturé, plus ce bruit de corrélation est important. Ainsi, une méthode pour déterminer le gain d'amplification optimal consiste à choisir le gain maximal pour lequel le nombre de points dépassant ce seuil est inférieur à une valeur prédéterminée. Autrement dit, le nombre de points correspondant à des pics du bruit de quantification est limité.

On décrit à présent un autre mode de réalisation de l'invention pour lequel le principe décrit ci-dessus est élargi dans le but de supprimer, dans le signal prélevé par le coupleur CPL, un ou plusieurs échos du signal sur une ou plusieurs discontinuités d'impédance associées à des points caractéristiques de la topologie d'un réseau de câbles. Ces points caractéristiques comprennent notamment, des points de jonction entre deux branches de câbles n'ayant pas la même impédance caractéristique ou des points d'extrémité de câbles ou de jonctions de câbles. Plus généralement, un point caractéristique est un point d'un réseau de câbles où se situe une discontinuité d'impédance qui est connue car liée à la topologie du réseau et non à un défaut. Ces discontinuités d'impédance entrainent des réflexions du signal qui sont rétro-propagées et qui s'additionnent aux réflexions sur les discontinuités liées au défaut. Dans le réflectogramme final, ces réflexions entrainent des pics d'amplitude qui peuvent masquer les pics liés aux défauts qui sont souvent d'amplitude plus faible.

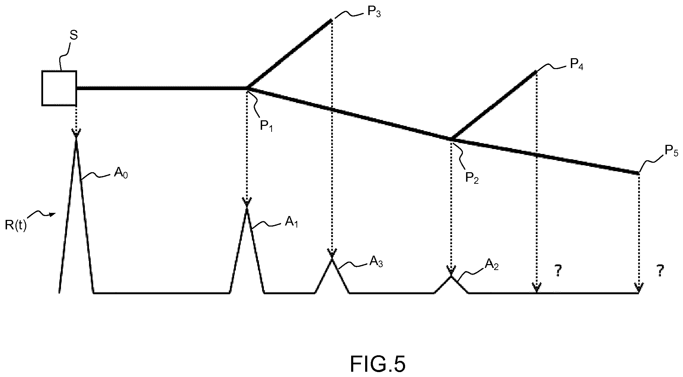

La figure 5 illustre, sur un schéma, un exemple de réseau de câbles comprenant deux points P1,P2 situés à des jonctions entre différentes branches du réseau et trois points P3,P4,P5 situés à des extrémités de jonctions de câbles du réseau. En effectuant une analyse de ce réseau à l'aide d'un système S de réflectométrie, le réflectogramme temporel R(t) obtenu par le corrélateur CORR est représenté sur le bas de la figure 5. Il comporte plusieurs pics de corrélation correspondant à différents points caractéristiques du réseau de câbles. Le pic A₀ correspond à une discontinuité d'impédance entre le coupleur CPL et le câble. Les pics A₁,A₃,A₂ correspondent respectivement aux discontinuités d'impédances provoquées par les points P₁,P₃,P₂. Les pics de corrélation du réflectogramme sont de plus en plus atténués avec la distance qui augmente entre le point caractéristique et le système de réflectométrie S.

La figure 5 illustre le fait qu'il peut être souhaitable d'annuler certains de ces pics qui peuvent masquer des pics de corrélation plus faibles correspondant à des défauts que l'on souhaite détecter.

Dans un second mode de réalisation de l'invention, le dispositif décrit à la figure 2 est modifié de la façon suivante afin de supprimer, dans le signal prélevé par le coupleur CPL, un ou plusieurs échos du signal injecté sur un ou plusieurs points caractéristiques d'un réseau de câbles.

Le second convertisseur numérique-analogique DAC_2 comporte une fréquence d'échantillonnage plus élevée que celle du premier convertisseur numérique-analogique DAC_1 afin de pouvoir générer des signaux avec des déphasages plus fins. Cette fonctionnalité est nécessaire pour permettre la génération de signaux de calibration en phase avec les échos que l'on souhaite annuler et qui n'ont pas forcément des retards multiples de la période d'échantillonnage du premier convertisseur numérique-analogique DAC_1. En effet, les retards des différents échos sont liés aux distances entre le coupleur CPL et les points caractéristiques P₁,P₃,P₂ et ne correspondent pas forcément à des multiples de la période d'une seule horloge. Pour cette raison, il est nécessaire d'utiliser un convertisseur DAC_2 avec une fréquence d'échantillonnage élevée.

L'unité de contrôle CTRL est configurée pour itérer l'opération décrite précédemment pour annuler l'écho de désadaptation entre le coupleur et la ligne L, afin d'annuler un ou plusieurs autres échos. Pour cela, pour chaque nouvel écho à supprimer, l'unité de contrôle CTRL génère un nouveau signal de calibration qui se superpose au signal de calibration précédemment généré. Par analyse du réflectogramme calculé par le corrélateur CORR autour d'une zone temporelle correspondant à la zone de l'écho que l'on souhaite annuler, l'unité de contrôle CTRL détermine l'amplitude et la phase du second signal de calibration qui est additionné au premier signal de calibration. La connaissance de la topologie du réseau de câbles peut être utilisée pour limiter les plages de variation de la phase et de l'amplitude des signaux générés par l'unité de contrôle CTRL, par exemple en limitant les valeurs des déphasages à une plage de retards calculés à partir de la distance entre le point d'injection du signal et le point de désadaptation d'impédance associé à l'écho que l'on souhaite supprimer. Ce processus est itéré pour chaque écho à supprimer. Le signal de calibration final qui est produit sur une entrée du combineur COMB correspond à la superposition de plusieurs signaux de calibration correspondant chacun à un écho à supprimer.

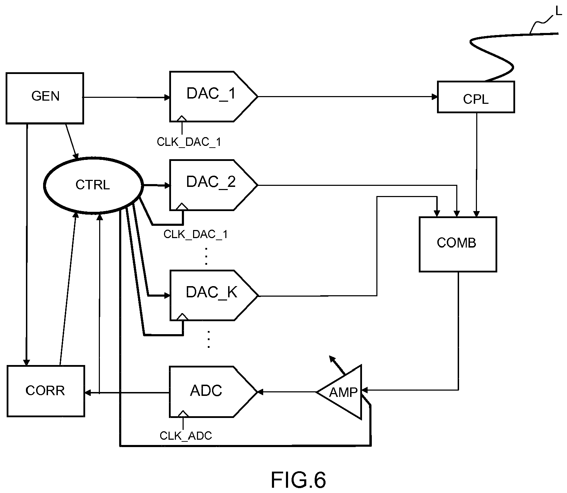

La figure 6 représente une variante du second mode de réalisation de l'invention dans lequel, on utilise plusieurs convertisseurs numérique-analogique DAC_2... DAC_K, en parallèle pour générer autant de signaux de calibration que d'échos à annuler. Les convertisseurs DAC_2,...DAC_K sont identiques au premier convertisseur DAC_1 et en particulier présentent la même fréquence d'échantillonnage. De ce fait, il est nécessaire d'utiliser un convertisseur pour chaque écho à supprimer afin de pouvoir ajuster précisément le déphasage du signal de calibration pour chaque écho.

Tous les signaux de sortie des différents convertisseurs DAC_2,...DAC_K sont produits en entrée du combineur COMB pour être combiner au signal prélevé par le coupleur CPL afin d'annuler les différents échos indésirables.

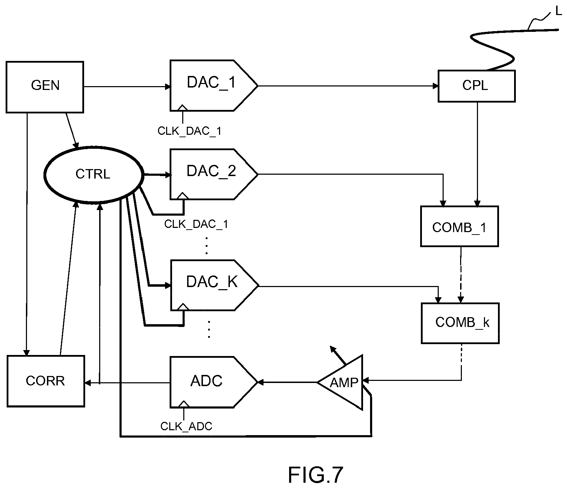

La figure 7 représente une autre variante du second mode de réalisation de l'invention dans laquelle on utilise plusieurs combineurs COMB_1,...,COMB k ayant chacun deux entrées, pour additionner successivement les signaux de calibration au signal prélevé par le coupleur CPL.

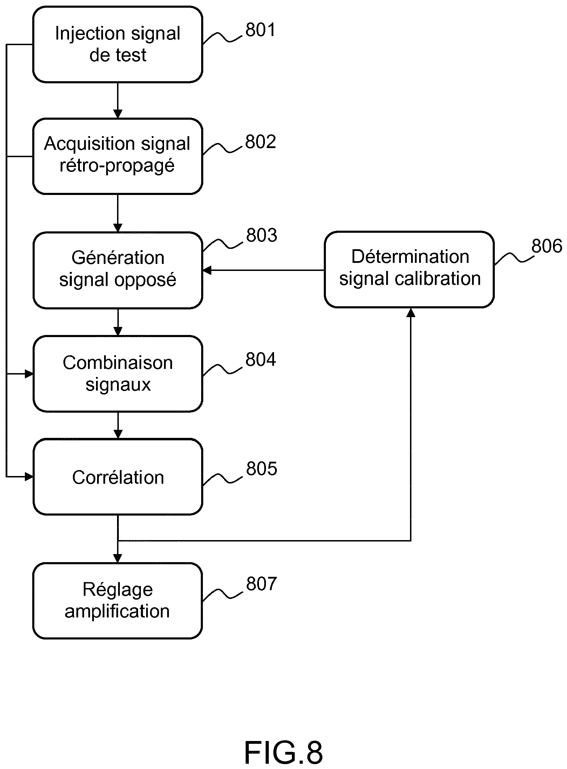

La figure 8 schématise, sur un organigramme, les étapes de mise en oeuvre d'un procédé de réflectométrie selon l'invention.

Dans une première étape 801, un signal de test est injecté dans la ligne L ou le réseau de lignes à analyser. Le signal de test est généré par un générateur GEN et injecté au moyen d'un coupleur CPL ou tout autre moyen d'injection équivalent.

Dans une deuxième étape 802. Le signal est prélevé ou acquis après sa rétro-propagation dans la ligne L ou le réseau de lignes. L'acquisition du signal rétro-propagé est effectuée au moyen du coupleur CPL ou tout autre moyen de mesure équivalent.

Dans une troisième étape 803, l'unité de contrôle CTRL génère un signal opposé au signal de référence et atténué par rapport au signal de référence.

Dans une quatrième étape 804, le signal opposé est combiné avec le signal acquis à l'étape 802 dans le but d'annuler l'écho du signal sur la discontinuité d'impédance entre le coupleur CPL et la ligne L.

Dans une cinquième étape 805, le corrélateur CORR détermine, par corrélation entre le signal de test et le signal combiné à l'étape 804, un réflectogramme temporel qui est transmis à l'unité de contrôle CTRL pour être analysé.

Dans une sixième étape 806, l'unité de contrôle CTRL ajuste la phase (ou le retard) et l'amplitude du signal opposé afin de déterminer un signal de calibration qui permet d'annuler, dans le réflectogramme, le pic de corrélation correspondant à l'écho à supprimer. Pour cela, les étapes 803,804,805 et 806 peuvent être itérées.

Lorsque le signal de calibration est déterminé, les étapes 803,804,805,806 peuvent être renouvelées pour générer un autre signal de calibration visant à annuler un autre écho du signal sur une autre discontinuité d'impédance. Le signal de calibration final résulte de la combinaison des différents signaux de calibration générés pour chaque écho à supprimer.

Une fois que le signal de calibration définitif est déterminé pour l'ensemble des échos à supprimer, le gain d'amplification est réglé 807 de sorte à adapter l'amplification aux signatures de défauts non francs.

Le système selon l'une quelconque des variantes de réalisation de l'invention peut être mis en oeuvre par une carte électronique sur laquelle sont disposés les différents composants. La carte peut être connectée au câble à analyser par un moyen de couplage CPL qui peut être un coupleur directionnel à effet capacitif ou inductif ou encore une connexion ohmique. Le dispositif de couplage peut être réalisé par des connecteurs physiques qui relient le générateur de signal au câble ou par des moyens sans contact, par exemple en utilisant un cylindre métallique dont le diamètre interne est sensiblement égal au diamètre externe du câble et qui produit un effet de couplage capacitif avec le câble.

En outre, une unité de traitement, de type ordinateur, assistant numérique personnel ou autre dispositif électronique ou informatique équivalent peut être utilisé pour piloter le système selon l'invention et afficher les résultats des calculs effectués par le corrélateur CORR sur une interface homme-machine, en particulier le réflectogramme R(t) et/ou les informations de détection et localisation de défauts sur le câble.

Le procédé selon l'invention, en particulier l'unité de contrôle CTRL peut être implémentée dans un processeur embarqué ou dans un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro-contrôleur par exemple) exécutant un programme comprenant une séquence d'instructions, ou sur une machine de calcul dédiée (par exemple un ensemble de portes logiques comme un FPGA ou un ASIC, ou tout autre module matériel).

## Revendications

1. Système d'analyse, par réflectométrie, de défauts dans une ligne de transmission (L), le système comprenant un générateur (GEN) de signal de test, un coupleur (CPL) pour injecter le signal de test dans la ligne de transmission (L) et prélever le signal rétro-propagé dans la ligne de transmission, une unité de contrôle (CTRL) configurée pour générer un signal de calibration dont les échantillons sont égaux à l'opposé des échantillons du signal de test et pour contrôler la phase et l' amplitude du signal de calibration, au moins un combineur (COMB) pour combiner le signal de calibration et le signal prélevé par le coupleur en un signal corrigé, un amplificateur (AMP) pour amplifier le signal corrigé et un corrélateur (CORR) pour corréler le signal corrigé et le signal de test pour produire un réflectogramme, l'unité de contrôle (CTRL) étant en outre configurée pour faire varier l'amplitude et la phase du signal de calibration de manière à supprimer, dans le signal prélevé par le coupleur (CPL), au moins un écho du signal de test sur au moins un point de désadaptation d'impédance de la ligne de transmission (L).

2. Système d'analyse de défauts selon la revendication 1 dans lequel le point de désadaptation d'impédance est le point de jonction entre le coupleur (CPL) et la ligne de transmission (L).

3. Système d'analyse de défauts selon l'une des revendications précédentes dans lequel l'unité de contrôle (CTRL) est configurée pour déterminer l'amplitude et la phase du signal de calibration en analysant le réflectogramme calculé par le corrélateur (CORR), les valeurs choisies de l'amplitude et de la phase étant celles permettant d'annuler, dans le réflectogramme, un pic d'amplitude correspondant à l'au moins un écho du signal de test sur au moins un point de désadaptation d'impédance de la ligne de transmission (L).

4. Système d'analyse de défauts selon l'une des revendications précédentes dans lequel le système comprend un premier convertisseur numérique-analogique (DAC_1) connecté entre le générateur (GEN) de signal de test et le coupleur (CPL), au moins un deuxième convertisseur numérique-analogique (DAC_2) connecté entre l'unité de contrôle (CTRL) et l'au moins un combineur (COMB) et un convertisseur analogique-numérique (ADC) connecté entre l'amplificateur (AMP) et le corrélateur (CORR).

5. Système d'analyse de défauts selon la revendication 4 dans lequel l'unité de contrôle (CTRL) est en outre configurée pour régler le gain d'amplification de l'amplificateur (AMP) de manière à ce que le signal analogique corrigé occupe toute la dynamique du convertisseur analogique-numérique (ADC) lorsque l'au moins un écho est supprimé dans le signal prélevé par le coupleur (CPL).

6. Système d'analyse de défauts selon la revendication 5 dans lequel l'unité de contrôle (CTRL) est configurée pour régler le gain d'amplification de l'amplificateur (AMP) en fonction d'un indicateur de saturation du convertisseur analogique-numérique (ADC).

7. Système d'analyse de défauts selon la revendication 5 dans lequel l'unité de contrôle (CTRL) est configurée pour régler le gain d'amplification de l'amplificateur (AMP) en fonction d'un critère de rapport signal à bruit mesuré sur le réflectogramme calculé par le corrélateur (CORR).

8. Système d'analyse de défauts selon la revendication 4 dans lequel l'unité de contrôle (CTRL) est configurée pour supprimer, dans le signal prélevé par le coupleur (CPL), plusieurs échos du signal de test sur plusieurs points de désadaptation d'impédance de la ligne de transmission (L) en exécutant successivement les étapes suivantes, pour chaque écho à supprimer :
- Générer un signal de calibration dont les échantillons sont égaux à l'opposé de ceux du signal de test,
- Déterminer l'amplitude et la phase du signal de calibration de manière à supprimer, dans le signal prélevé par le coupleur (CPL), l'écho.

9. Système d'analyse de défauts selon la revendication 8 dans lequel les points de désadaptation d'impédance comprennent au moins le point de jonction entre le coupleur (CPL) et la ligne de transmission (L) et un point parmi un point de jonction entre deux tronçons de la ligne de transmission ou une extrémité d'une jonction de la ligne de transmission (L).

10. Système d'analyse de défauts selon l'une des revendications 8 ou 9 dans lequel le premier convertisseur numérique-analogique (DAC_1) a une première fréquence et le second convertisseur numérique-analogique (DAC_2) a une seconde fréquence supérieure à la première fréquence.

11. Système d'analyse de défauts selon l'une des revendications 8 ou 9 comprenant au moins un convertisseur numérique-analogique supplémentaire (DAC_K), les convertisseurs numérique-analogique (DAC_1, DAC_2,DAC_K) étant identiques, au moins certains des convertisseurs numériques-analogiques (DAC_2,DAC_K) étant agencés entre une sortie de l'unité de contrôle (CTRL) et une entrée du combineur (COMB) pour convertir respectivement, chacun des signaux de calibration générés par l'unité de contrôle en signaux analogiques.

12. Système d'analyse de défauts selon la revendication 11 comprenant plusieurs combineurs (COMB_1,..COMB_k) agencés en cascade, chaque combineur ayant une entrée reliée à une sortie distincte du second convertisseur numérique-analogique (DAC_2) ou de l'un des convertisseurs numérique-analogique supplémentaires (DAC_K).

13. Système d'analyse de défauts selon l'une des revendications précédentes comprenant un dispositif d'analyse du réflectogramme calculé par le corrélateur (CORR) pour analyser la présence de défaut sur la ligne de transmission (L).

14. Procédé d'analyse, par réflectométrie, de défauts dans une ligne de transmission (L), le procédé comprenant les étapes de :
- Injecter (801) un signal de test au moyen d'un coupleur (CPL) connecté à la ligne de transmission (L),
- Acquérir (802) un signal rétro-propagé dans la ligne de transmission, au moyen du coupleur (CPL),
- Générer (803) un signal de calibration dont les échantillons sont égaux à l'opposé de ceux du signal de test et ayant une amplitude et une phase contrôlable,
- Combiner (804) le signal de calibration et le signal rétro-propagé pour obtenir un signal corrigé,
- Déterminer (806) l'amplitude et la phase du signal de calibration de manière à supprimer, dans le signal rétro-propagé, au moins un écho du signal de test sur au moins un point de désadaptation d'impédance de la ligne de transmission (L).

15. Procédé d'analyse de défauts selon la revendication 14 comprenant les étapes de :
- Corréler (805) le signal corrigé et le signal de test pour obtenir un réflectogramme,
- Déterminer (806) l'amplitude et la phase du signal de calibration de sorte à annuler, dans le réflectogramme, un pic d'amplitude correspondant à l'au moins un écho du signal de test.

16. Procédé d'analyse de défauts selon l'une des revendications 14 ou 15 comprenant les étapes de :
- Déterminer (807) un gain d'amplification du signal corrigé de manière à ce que le signal corrigé occupe toute la dynamique d'un convertisseur analogique-numérique (ADC) lorsque l'au moins un écho est supprimé dans le signal prélevé par le coupleur (CPL).
- Amplifier le signal corrigé avec le gain d'amplification.

## Patentansprüche

1. System zum Analysieren, durch Reflektometrie, von Fehlern in einer Übertragungsleitung (L), wobei das System Folgendes umfasst: einen Testsignalgenerator (GEN), einen Koppler (CPL) zum Einspeisen des Testsignals in die Übertragungsleitung (L) und zum Abgreifen des in der Übertragungsleitung rückgeführten Signals, eine Steuereinheit (CTRL), konfiguriert zum Erzeugen eines Kalibriersignals, dessen Samples gleich dem Gegenteil der Samples des Testsignals sind, und zum Steuern der Phase und der Amplitude des Kalibriersignals, mindestens einen Kombinierer (COMB) zum Kombinieren des Kalibriersignals und des vom Koppler abgegriffenen Signals zu einem korrigierten Signal, einen Verstärker (AMP) zum Verstärken des korrigierten Signals und einen Korrelator (CORR) zum Korrelieren des korrigierten Signals und des Testsignals, um ein Reflektogramm zu erzeugen, wobei die Steuereinheit (CTRL) ferner zum Variieren der Amplitude und der Phase des Kalibriersignals konfiguriert ist, um in dem von dem Koppler (CPL) abgegriffenen Signal mindestens ein Echo des Testsignals an mindestens einem Impedanzfehlübereinstimmungspunkt der Übertragungsleitung (L) zu unterdrücken.

2. Fehleranalysesystem nach Anspruch 1, wobei der Impedanzfehlübereinstimmungspunkt der Verbindungspunkt zwischen dem Koppler (CPL) und der Übertragungsleitung (L) ist.

3. Fehleranalysesystem nach einem der vorhergehenden Ansprüche, wobei die Steuereinheit (CTRL) zum Bestimmen der Amplitude und der Phase des Kalibriersignals durch Analysieren des vom Korrelator (CORR) berechneten Reflektogramms konfiguriert ist, wobei die gewählten Werte der Amplitude und der Phase diejenigen sind, die es zulassen, im Reflektogramm eine Amplitudenspitze zu löschen, die dem mindestens einen Echo des Testsignals an mindestens einem Impedanzfehlübereinstimmungspunkt der Übertragungsleitung (L) entspricht.

4. Fehleranalysesystem nach einem der vorhergehenden Ansprüche, wobei das System einen zwischen dem Testsignalgenerator (GEN) und dem Koppler (CPL) angeschlossenen ersten Digital-Analog-Wandler (DAC_1), mindestens einen zwischen der Steuereinheit (CTRL) und dem mindestens einen Kombinator (COMB) angeschlossenen zweiten Digital-Analog-Wandler (DAC_2) und einen zwischen dem Verstärker (AMP) und dem Korrelator (CORR) angeschlossenen Analog-Digital-Wandler (ADC) umfasst.

5. Fehleranalysesystem nach Anspruch 4, wobei die Steuereinheit (CTRL) ferner zum Regeln des Verstärkungsfaktors des Verstärkers (AMP) konfiguriert ist, so dass das korrigierte analoge Signal die gesamte Dynamik des Analog-Digital-Wandlers (ADC) einnimmt, wenn das mindestens eine Echo in dem vom Koppler (CPL) abgegriffenen Signal unterdrückt wird.

6. Fehleranalysesystem nach Anspruch 5, wobei die Steuereinheit (CTRL) zum Regeln des Verstärkungsfaktors des Verstärkers (AMP) in Abhängigkeit von einem Indikator für die Sättigung des Analog-Digital-Wandlers (ADC) konfiguriert ist.

7. Fehleranalysesystem nach Anspruch 5, wobei die Steuereinheit (CTRL) zum Regeln des Verstärkungsfaktors des Verstärkers (AMP) in Abhängigkeit von einem Kriterium für das auf dem vom Korrelator (CORR) berechneten Reflektogramm gemessene Signal-Rausch-Verhältnis konfiguriert ist.

8. Fehleranalysesystem nach Anspruch 4, wobei die Steuereinheit (CTRL) zum Unterdrücken, in dem vom Koppler (CPL) abgegriffenen Signal, mehrerer Echos des Testsignals an mehreren Impedanzfehlübereinstimmungspunkten der Übertragungsleitung (L) durch Ausführen nacheinander der folgenden Schritte für jedes zu unterdrückende Echo konfiguriert ist:
- Erzeugen eines Kalibriersignals, dessen Samples gleich dem Gegenteil der Samples des Testsignals sind,
- Bestimmen der Amplitude und der Phase des Kalibriersignals, um das Echo in dem vom Koppler (CPL) abgegriffenen Signal zu unterdrücken.

9. Fehleranalysesystem nach Anspruch 8, wobei die Impedanzfehlübereinstimmungspunkte mindestens den Verbindungspunkt zwischen dem Koppler (CPL) und der Übertragungsleitung (L) und einen Punkt von einem Verbindungspunkt zwischen zwei Abschnitten der Übertragungsleitung oder einem Ende einer Verbindungsstelle der Übertragungsleitung (L) umfassen.

10. Fehleranalysesystem nach Anspruch 8 oder 9, wobei der erste Digital-Analog-Wandler (DAC_1) eine erste Frequenz hat und der zweite Digital-Analog-Wandler (DAC_2) eine zweite Frequenz hat, die höher ist als die erste Frequenz.

11. Fehleranalysesystem nach Anspruch 8 oder 9, das mindestens einen zusätzlichen Digital-Analog-Wandler (DAC_K) umfasst, wobei die Digital-Analog-Wandler (DAC_1, DAC_2, DAC_K) identisch sind, wobei mindestens einige der Digital-Analog-Wandler (DAC_2, DAC_K) zwischen einem Ausgang der Steuereinheit (CTRL) und einem Eingang des Kombinierers (COMB) angeordnet sind, um jeweils jedes der von der Steuereinheit erzeugten Kalibriersignale in Analogsignale umzuwandeln.

12. Fehleranalysesystem nach Anspruch 11, das mehrere in Kaskade angeordnete Kombinierer (COMB_1, ..., COMB_k) umfasst, wobei jeder Kombinierer einen Eingang hat, der mit einem separaten Ausgang des zweiten Digital-Analog-Wandlers (DAC_2) oder eines der zusätzlichen Digital-Analog-Wandler (DAC_K) verbunden ist.

13. Fehleranalysesystem nach einem der vorhergehenden Ansprüche, das eine Vorrichtung zum Analysieren des vom Korrelator (CORR) berechneten Reflektogramms umfasst, um das Vorhandensein eines Fehlers auf der Transmissionsleitung (L) zu analysieren.

14. Verfahren zum Analysieren, durch Reflektometrie, von Fehlern in einer Transmissionsleitung (L), wobei das Verfahren die folgenden Schritte umfasst:
- Einspeisen (801) eines Testsignals mittels eines Kopplers (CPL), der mit der Übertragungsleitung (L) verbunden ist,
- Erfassen (802) eines rückgeführten Signals in der Übertragungsleitung mittels des Kopplers (CPL),
- Erzeugen (803) eines Kalibriersignals, dessen Samples gleich dem Gegenteil der Samples des Testsignals sind und eine steuerbare Amplitude und Phase haben,
- Kombinieren (804) des Kalibriersignals und des rückgeführten Signals, um ein korrigiertes Signal zu erhalten,
- Bestimmen (806) der Amplitude und der Phase des Kalibriersignals, um in dem rückgeführten Signal mindestens ein Echo des Testsignals an mindestens einem Impedanzfehlübereinstimmungspunkt der Übertragungsleitung (L) zu unterdrücken.

15. Verfahren zum Analysieren von Fehlern nach Anspruch 14, das die folgenden Schritte umfasst:
- Korrelieren (805) des korrigierten Signals und des Testsignals, um ein Reflektogramm zu erhalten,
- Bestimmen (806) der Amplitude und der Phase des Kalibriersignals, um im Reflektogramm einen Amplitudenpeak zu löschen, der dem mindestens einen Echo des Testsignals entspricht.

16. Verfahren zum Analysieren von Fehlern nach Anspruch 14 oder 15, das die folgenden Schritte umfasst:
- Bestimmen (807) eines Verstärkungsfaktors des korrigierten Signals, so dass das korrigierte Signal die gesamte Dynamik eines Analog-Digital-Wandlers (ADC) einnimmt, wenn das mindestens eine Echo in dem von dem Koppler (CPL) abgegriffenen Signal unterdrückt wird,
- Verstärken des korrigierten Signals mit dem Verstärkungsfaktor.

## Claims

1. A system for analysing, by reflectometry, faults in a transmission line (L), the system comprising a test signal generator (GEN), a coupler (CPL) for injecting the test signal into the transmission line (L) and sampling the signal back-propagated in the transmission line, a control unit (CTRL) configured to generate a calibration signal, the samples of which are equal to the opposite of the samples of the test signal and to control the phase and the amplitude of the calibration signal, at least one combiner (COMB) for combining the calibration signal and the signal sampled by the coupler into a corrected signal, an amplifier (AMP) for amplifying the corrected signal and a correlator (CORR) for correlating the corrected signal and the test signal to produce a reflectogram, the control unit (CTRL) being further configured to make the amplitude and the phase of the calibration signal vary so as to eliminate, in the signal sampled by the coupler (CPL), at least one echo of the test signal on at least one point of impedance mismatch of the transmission line (L).

2. The system for analysing faults according to claim 1, wherein the point of impedance mismatch is the junction point between the coupler (CPL) and the transmission line (L).

3. The system for analysing faults according to one of the preceding claims, wherein the control unit (CTRL) is configured to determine the amplitude and the phase of the calibration signal by analysing the reflectogram calculated by the correlator (CORR), the values selected for the amplitude and the phase being those that allow the cancellation, in the reflectogram, of an amplitude peak corresponding to the at least one echo of the test signal on at least one point of impedance mismatch of the transmission line (L).

4. The system for analysing faults according to one of the preceding claims, wherein the system comprises a first digital-analog converter (DAC_1) connected between the test signal generator (GEN) and the coupler (CPL), at least one second digital-analog converter (DAC_2) connected between the control unit (CTRL) and the at least one combiner (COMB) and an analog-digital converter (ADC) connected between the amplifier (AMP) and the correlator (CORR).

5. The system for analysing faults according to claim 4, wherein the control unit (CTRL) is further configured to adjust the amplification gain of the amplifier (AMP) so that the corrected analog signal occupies the entire dynamic range of the analog-digital converter (ADC) when the at least one echo is eliminated in the signal sampled by the coupler (CPL).

6. The system for analysing faults according to claim 5, wherein the control unit (CTRL) is configured to adjust the amplification gain of the amplifier (AMP) as a function of an indicator of saturation of the analog-digital converter (ADC).

7. The system for analysing faults according to claim 5, wherein the control unit (CTRL) is configured to adjust the amplification gain of the amplifier (AMP) as a function of a signal-to-noise ratio criterion measured on the reflectogram calculated by the correlator (CORR).

8. The system for analysing faults according to claim 4, wherein the control unit (CTRL) is configured to eliminate, in the signal sampled by the coupler (CPL), several echoes of the test signal on several points of impedance mismatch of the transmission line (L) by successively executing the following steps, for each echo to be eliminated:
- generating a calibration signal, the samples of which are equal to the opposite of those of the test signal,
- determining the amplitude and the phase of the calibration signal so as to eliminate the echo from the signal sampled by the coupler (CPL).

9. The system for analysing faults according to claim 8, wherein the points of impedance mismatch comprise at least the junction point between the coupler (CPL) and the transmission line (L) and one point from among a junction point between two sections of the transmission line or one end of a junction of the transmission line (L).

10. The system for analysing faults according to one of claim 8 or 9, wherein the first digital-analog converter (DAC_1) has a first frequency and the second digital-analog converter (DAC_2) has a second frequency higher than the first frequency.

11. The system for analysing faults according to one of claim 8 or 9, comprising at least one additional digital-analog converter (DAC_K), the digital-analog converters (DAC_1, DAC_2, DAC_K) being identical, at least some of the digital-analog converters (DAC_2, DAC_K) being arranged between an output of the control unit (CTRL) and an input of the combiner (COMB) to convert, respectively, each of the calibration signals generated by the control unit into analog signals.

12. The system for analysing faults according to claim 11, comprising several combiners (COMB_1, ..., COMB_k) arranged in cascade fashion, each combiner having an input linked to a distinct output of the second digital-analog converter (DAC_2) or of one of the additional digital-analog converter (DAC_K).

13. The system for analysing faults according to one of the preceding claims, comprising a device for analysing the reflectogram calculated by the correlator (CORR) to analyse the presence of faults on the transmission line (L).

14. A method for analysing, by reflectometry, faults in a transmission line (L), the method comprising the steps of:
- injecting (801) a test signal by means of a coupler (CPL) connected to the transmission line (L),
- acquiring (802) a signal back-propagated in the transmission line, by means of the coupler (CPL),
- generating (803) a calibration signal, the samples of which are equal to the opposite of those of the test signal and having an amplitude and a controllable phase,
- combining (804) the calibration signal and the back-propagated signal to obtain a corrected signal,
- determining (806) the amplitude and the phase of the calibration signal so as to eliminate, in the back-propagated signal, at least one echo of the test signal on at least one point of impedance mismatch of the transmission line (L).

15. The method for analysing faults according to claim 14, comprising the steps of:
- correlating (805) the corrected signal and the test signal to obtain a reflectogram,
- determining (806) the amplitude and the phase of the calibration signal so as to cancel, in the reflectogram, an amplitude peak corresponding to the at least one echo of the test signal.

16. The method for analysing faults according to one of claims 14 and 15, comprising the steps of:
- determining (807) an amplification gain of the corrected signal so that the corrected signal occupies the entire dynamic range of an analog-digital converter (ADC) when the at least one echo is eliminated in the signal sampled by the coupler (CPL),
- amplifying the corrected signal with the amplification gain.
